# EUROPÄISCHE PATENTSCHRIFT

(11) **EP 4 204 826 B1**
(45) Veröffentlichungstag und Bekanntmachung des Hinweises auf die Patenterteilung: **04.12.2024**
(21) Anmeldenummer: 21742409.2
(22) Anmeldetag: 13.07.2021
(51) Int. Cl.: G01R 31/28, G01R 31/319, G01S 13/00, G01S 17/00

(54) **PROGRAMMIERBARE SIGNALVERARBEITUNGSEINHEIT UND VERFAHREN ZUM BETRIEB EINER PROGRAMMIERBAREN SIGNALVERARBEITUNGSEINHEIT**
PROGRAMMABLE SIGNAL PROCESSING UNIT AND METHOD FOR OPERATING A PROGRAMMABLE SIGNAL PROCESSING UNIT
UNITÉ DE TRAITEMENT DE SIGNAL PROGRAMMABLE ET PROCÉDÉ DE FONCTIONNEMENT D'UNE UNITÉ DE TRAITEMENT DE SIGNAL PROGRAMMABLE

(30) Priorität: 28.08.2020 DE 102020005295
(43) Veröffentlichungstag der Anmeldung: 05.07.2023
(73) Patentinhaber: SEW-EURODRIVE GmbH & Co. KG, 76646 Bruchsal (DE)
(72) Erfinder: HUA, Zhidong, 76646 Bruchsal (DE); SCHÄFER, Thomas, 76689 Karlsdorf-Neuthard (DE); AYHAN, Serdal, 69234 Dielheim (DE); KOCH, Christian, 76356 Weingarten (DE); TOSCH, Maximilian, 45549 Sprockhövel (DE)
(86) Internationale Anmeldenummer: PCT/EP2021/069499
(87) Internationale Veröffentlichungsnummer: WO 2022/042929

(56) Entgegenhaltungen:
- DE-A1- 102014 114 877
- DE-A1- 102019 202 472
- US-A1- 2019 392 702
- CUI KE ET AL: "FPGA-based interrogation controller with optimized pipeline architecture for very large-scale fiber-optic interferometric sensor arrays", OPTICS AND LASERS IN ENGINEERING, vol. 121, 1 October 2019 (2019-10-01), AMSTERDAM, NL, pages 389 - 396, XP055851026, ISSN: 0143-8166, Retrieved from the Internet <URL:https://www.sciencedirect.com/science/article/pii/S014381661930079X/pdfft?md5=be03ad3c6efee5fb961eddac531f2140&pid=1-s2.0-S014381661930079X-main.pdf> [retrieved on 20211013], DOI: 10.1016/j.optlaseng.2019.04.026

## Beschreibung

Die Erfindung betrifft eine programmierbare Signalverarbeitungseinheit, umfassend eine Sensoreingangseinheit zur Erfassung von Sensorsignalen sowie zur Ausgabe von Sensordaten, eine Mehrzahl von Modulen zur Verarbeitung von Daten und eine Ausgangseinheit zur Erfassung von verarbeiteten Daten sowie zur Ausgabe von Ausgangssignalen, wobei die Sensordaten einem ersten Modul zuführbar sind, und von einem letzten Modul verarbeitete Daten der Ausgangseinheit zuführbar sind. Die Erfindung betrifft auch ein Verfahren zum Betrieb einer programmierbaren Signalverarbeitungseinheit.

Programmierbare Signalverarbeitungseinheiten, die auch als FPGA (Field Programmable Gate Array) bezeichnet werden, dienen beispielsweise zur Auswertung von Radarsignalen von Radarsensoren. Dabei ist die Sensoreingangseinheit mit einem Radarsensor verbunden, welcher der Sensoreingangseinheit Sensorsignale zuführt. Die Ausgangseinheit ist beispielsweise mit einer Prozesssteuerung zur Steuerung eines technischen Prozesses verbunden, an welche die Ausgangssignale ausgegeben werden. Innerhalb einer Signalverarbeitungseinheit werden Daten in Modulen gemäß vorgebbaren Algorithmen verarbeitet.

Für die Entwicklung von Algorithmen in einem FPGA für beispielsweise die Radar-Signalverarbeitung werden Softwareumgebungen in einem PC eingesetzt, um die mathematischen Berechnungen für die Algorithmen mit Testsignalen zu simulieren oder mit aufgezeichneten Sensordaten zu testen. Anschließend werden die Algorithmen auf ein FPGA basiertes Echtzeitsystem implementiert. Im FPGA muss aufgrund von begrenzenden Ressourcen oder begrenzter Bit-Auflösung eine Anpassung der Algorithmen durchgeführt werden.

Für solche Systeme sind Entwicklungsumgebungen für die Simulation und für das Debuggen verfügbar. Für die Simulation müssen vorab Testbenches geschrieben werden, wodurch ein hoher Zeitaufwand resultiert. Für das Debuggen müssen vorab die zu untersuchenden Signale festgelegt werden, was zu einem zusätzlichen Ressourcenverbrauch durch die feste Verdrahtung im FPGA führt. Für jede Änderung dieser Signale oder der Testumgebung ist ein erneutes Kompilieren des Projektes erforderlich, was bei großen Projekten erheblichen Zeitaufwand bedeutet.

Aus der DE 10 2016 224 253 A1 sind ein Verfahren zum Überwachen eines Sensorsystems eines Fahrzeugs und ein Sensorsystem bekannt.

Aus der DE 10 2016 223 581 A1 sind eine Vorrichtung und ein Verfahren zum Überprüfen einer Funktionsfähigkeit eines Sensors bekannt.

Aus der DE 10 2019 106 632 A1 ist eine Fahrer-Assistenzsystem-Test-Schnittstelle für Automatisiertes-Fahren-Sensoren bekannt.

Aus der DE 103 38 922 A1 sind eine elektrische Diagnoseschaltung sowie ein Verfahren zum Testen und/oder zur Diagnose einer integrierten Schaltung bekannt.

Aus der DE 10 2014 114 877 A1 ist eine Vorrichtung zum Bereitstellen eines Ausgangsparameters bekannt. Die Vorrichtung umfasst eine Ausgangsparametergeneratorschaltung, eine Ausgangsschnittstellenschaltung und eine Testschaltung.

Aus der DE 10 2019 202 472 A1 sind ein Verfahren und ein System zum Durchführen der Verifizierung von Messungen durch einen Sensor in Quasi-Echtzeit bekannt.

Aus der US 2019/0392702 A1 ist ein integrierter Schaltkreis für einen Sensor bekannt, welcher zwei Verarbeitungskanäle umfasst.

Aus dem Dokument "FPGA-based interrogation controller with optimized pipeline architecture for very large-scale fiber-optic interferometric sensor arrays", OPTICS AND LASERS IN ENGINEERING, Bd. 121, 1. Oktober 2019 (2019-10-01), Seiten 389-396, XP055851026, ISSN: 0143-8166, DOI: 10.1016/j.optlaseng.2019.04.026 ist ein Sensorsystem mit einem Multiplexer bekannt.

Der Erfindung liegt die Aufgabe zugrunde, eine programmierbare Signalverarbeitungseinheit sowie ein Verfahren zum Betrieb einer programmierbaren Signalverarbeitungseinheit weiterzubilden.

Die Aufgabe wird durch eine programmierbare Signalverarbeitungseinheit mit den im Anspruch 1 angegebenen Merkmalen gelöst. Vorteilhafte Ausgestaltungen und Weiterbildungen sind Gegenstand der Unteransprüche. Die Aufgabe wird auch durch ein Verfahren zum Betrieb einer programmierbaren Signalverarbeitungseinheit mit den im Anspruch 8 angegebenen Merkmalen gelöst. Vorteilhafte Ausgestaltungen und Weiterbildungen sind Gegenstand der Unteransprüche.

Eine erfindungsgemäße Programmierbare Signalverarbeitungseinheit umfasst eine Sensoreingangseinheit zur Erfassung von Sensorsignalen sowie zur Ausgabe von Sensordaten, eine Mehrzahl von Modulen zur Verarbeitung von Daten und eine Ausgangseinheit zur Erfassung von verarbeiteten Daten sowie zur Ausgabe von Ausgangssignalen, wobei die Sensordaten einem ersten Modul zuführbar sind, und von einem letzten Modul verarbeitete Daten der Ausgangseinheit zuführbar sind. Die programmierbare Signalverarbeitungseinheit umfasst auch eine Testausgabeeinheit zur Ausgabe von Testausgangssignalen und einen Ausgangsmultiplexer, wobei der Ausgangsmultiplexer derart mit der Mehrzahl von Modulen und mit der Testausgabeeinheit verbunden ist, dass von den Modulen verarbeitete Daten dem Ausgangsmultiplexer zuführbar sind, und dass von dem Ausgangsmultiplexer ausgegebene Daten der Testausgabeeinheit zuführbar sind.

Einem Digitalrechner, der mit der Testausgabeeinheit verbunden ist, sind somit wahlweise die von jedem der Module verarbeiteten Daten sowie die Sensordaten zuführbar. Damit ist, insbesondere im Servicefall, eine separate Analyse jedes einzelnen Moduls zum Debuggen ermöglicht. Auch ist ein direkter Vergleich von zuvor simulierten Daten mit von den Modulen verarbeiteten Daten möglich. Die Entwicklung von Algorithmen in den Modulen der programmierbaren Signalverarbeitungseinheit ist damit vorteilhaft beschleunigt. Wiederholtes Rekompilieren während dem Debuggen und das Schreiben von Testbenches sind vermeidbar. Ferner ist eine Diagnosefähigkeit im Betrieb für den Servicefall oder Update-Fall sowie eine Datenlogger-Funktionalität gegeben.

Gemäß einer bevorzugten Ausgestaltung der Erfindung sind die von einem vorgehenden Modul verarbeiteten Daten einem jeweils nachfolgenden Modul zuführbar. Die einzelnen Module sind somit seriell verschaltet.

Gemäß einer vorteilhaften Ausgestaltung der Erfindung ist der Ausgangsmultiplexer derart mit der Sensoreingangseinheit verbunden, dass die Sensordaten dem Ausgangsmultiplexer zuführbar sind. Somit sind zum Debuggen auch die Sensordaten analysierbar, die von einem Sensor, der mit der Sensoreingangseinheit verbunden ist, gelieferten werden.

Gemäß einer vorteilhaften Weiterbildung der Erfindung umfasst die programmierbare Signalverarbeitungseinheit eine Testeingabeeinheit zur Erfassung von Testsignalen sowie zur Ausgabe von Testdaten und eine Mehrzahl von Eingangsmultiplexern, wobei ein erster Eingangsmultiplexer derart mit dem ersten Modul, mit der Testeingabeeinheit und mit der Sensoreingangseinheit verbunden ist, dass dem ersten Modul wahlweise die Sensordaten oder die Testdaten zuführbar sind, und wobei nachfolgende Eingangsmultiplexer derart mit den Modulen und mit der Testeingabeeinheit verbunden sind, dass jedem nachfolgenden Modul wahlweise die von einem vorgehenden Modul verarbeiteten Daten oder die Testdaten zuführbar sind.

Von einem Digitalrechner, der mit der Testeingabeeinheit verbunden ist, sind somit wahlweise jedem der Module beliebige Testdaten zuführbar. Damit ist jedes einzelne der Module mit beliebigen Testdaten untersuchbar. Jedes Modul ist nach dem gleichen Kommunikationsprotokoll ausgelegt, deshalb sind die Schnittstellen der Eingangsmultiplexer immer gleich. Somit ist eine Erweiterung für weitere Module sehr schnell umsetzbar.

Gemäß einer vorteilhaften Ausgestaltung der Erfindung ist ein finaler Eingangsmultiplexer derart mit dem letzten Modul, mit der Testeingabeeinheit und mit der Ausgangseinheit verbunden, dass der Ausgangseinheit wahlweise die von dem letzten Modul verarbeiteten Daten oder die Testdaten zuführbar sind. Damit sind einer Prozesssteuerung, die mit der Ausgangseinheit verbunden ist, ebenfalls beliebige Testdaten zuführbar.

Gemäß einer vorteilhaften Weiterbildung der Erfindung umfasst die programmierbare Signalverarbeitungseinheit eine Teststeuereinheit zur Erfassung von Steuersignalen sowie zur Ausgabe von Steuerdaten und einen Steuermultiplexer, wobei der Steuermultiplexer derart mit den Eingangsmultiplexern und mit der Teststeuereinheit verbunden ist, dass in Abhängigkeit von den Steuerdaten die Eingangsmultiplexer ansteuerbar sind. Von einem Digitalrechner, der mit der Teststeuereinheit verbunden ist, ist somit über den Steuermultiplexer auswählbar, an welcher Stelle, also an welchem der Module, die Testdaten eingefügt werden.

Gemäß einer vorteilhaften Ausgestaltung der Erfindung ist die Teststeuereinheit derart mit dem Ausgangsmultiplexer verbunden, dass in Abhängigkeit von den Steuerdaten der Ausgangsmultiplexer ansteuerbar ist. Von einem Digitalrechner, der mit der Teststeuereinheit verbunden ist, ist somit auswählbar, welche Daten der Testausgabeeinheit zugeführt werden.

Ein erfindungsgemäßes Verfahren zum Betrieb einer erfindungsgemäßen programmierbaren Signalverarbeitungseinheit ist dadurch gekennzeichnet, dass von der Sensoreingangseinheit Sensorsignale erfasst und Sensordaten ausgegeben werden; von der Mehrzahl von Modulen Daten verarbeitet werden; und von der Ausgangseinheit Ausgangssignale ausgegeben werden. Dabei werden von den Modulen verarbeitete Daten dem Ausgangsmultiplexer zugeführt; von dem Ausgangsmultiplexer ausgegebene Daten werden der Testausgabeeinheit zugeführt; und von der Testausgabeeinheit werden Testausgangssignale ausgegeben.

Gemäß einer vorteilhaften Weiterbildung der Erfindung werden dem Ausgangsmultiplexer auch die Sensordaten zugeführt.

Gemäß einer vorteilhaften Ausgestaltung der Erfindung werden von einer Testeingabeeinheit Testsignale erfasst und Testdaten ausgegeben, wobei dem ersten Modul über einen ersten Eingangsmultiplexer wahlweise die Sensordaten oder die Testdaten zugeführt werden; und jedem nachfolgenden Modul über einen nachfolgenden Eingangsmultiplexer wahlweise die von einem vorgehenden Modul verarbeiteten Daten oder die Testdaten zugeführt werden.

Gemäß einer vorteilhaften Weiterbildung der Erfindung werden der Ausgangseinheit über einen finalen Eingangsmultiplexer wahlweise die von dem letzten Modul verarbeiteten Daten oder die Testdaten zugeführt.

Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert. Die Erfindung ist nicht auf die in den Abbildungen dargestellten Ausführungsbeispiele beschränkt. Die Abbildungen stellen den Gegenstand der Erfindung nur schematisch dar. Es zeigen:

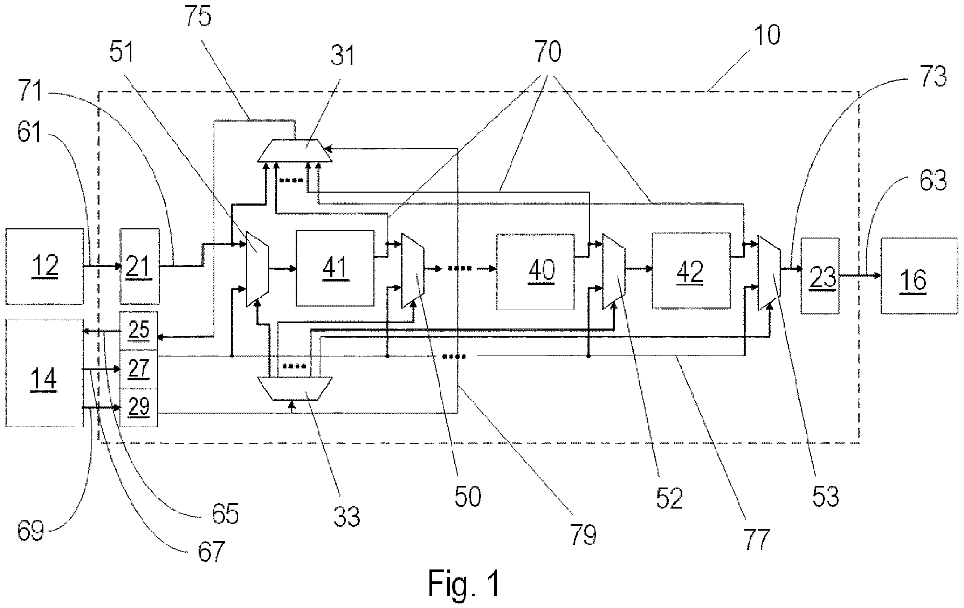

- Figur 1:: eine schematische Darstellung eines Systems mit einer programmierbaren Signalverarbeitungseinheit

Figur 1 zeigt eine schematische Darstellung eines Systems mit einer programmierbaren Signalverarbeitungseinheit 10. Die programmierbaren Signalverarbeitungseinheit 10 ist als FPGA (Field Programmable Gate Array) ausgebildet. Die programmierbare Signalverarbeitungseinheit 10 ist mit einem Sensor 12, einer Prozesssteuerung 16 und mit einem Digitalrechner 14 verbunden. Der Digitalrechner 14 dient vorliegend zur Überprüfung der programmierbaren Signalverarbeitungseinheit 10.

Der Sensor 12 ist vorliegend ein Radarsensor und liefert Radarsignale in Form von Sensorsignalen 61. Dabei handelt es sich insbesondere um niederfrequente Radarsignale, die in ein Basisband heruntergemischt sind. Die Prozesssteuerung 16 dient zur Steuerung eines technischen Prozesses. Der Sensor 12, die programmierbare Signalverarbeitungseinheit 10 und die Prozesssteuerung 16 sind beispielsweise in einem autonom fahrenden Fahrzeug eingesetzt. Der Sensor 12 erfasst mittels Radar Gegenstände, insbesondere Hindernisse und liefert Radarsignale in Form von Sensorsignalen 61 an die programmierbare Signalverarbeitungseinheit 10. Die programmierbaren Signalverarbeitungseinheit 10 berechnet daraus unter anderem Entfernungen zu erfassten Hindernissen und liefert diese in Form von Ausgangssignalen 63 an die Prozesssteuerung 16. Die Prozesssteuerung 16 steuert Fahrmanöver des autonom fahrenden Fahrzeugs und verhindert insbesondere Kollisionen mit erkannten Hindernissen.

Die programmierbaren Signalverarbeitungseinheit 10 umfasst eine Sensoreingangseinheit 21. Die Sensoreingangseinheit 21 ist mit dem Sensor 12 verbunden und dient zur Erfassung der von dem Sensor 12 gelieferten Sensorsignale 61. Die Sensoreingangseinheit 21 gibt digitale Sensordaten 71 aus. Die Sensordaten 71 enthalten die Sensorsignale 61. Die programmierbare Signalverarbeitungseinheit 10 umfasst auch eine Mehrzahl von Modulen 40, 41, 42 zur Verarbeitung von Daten. Die von der Sensoreingangseinheit 21 ausgegebenen digitalen Sensordaten 71 sind einem ersten Modul 41 zuführbar.

Die Module 40, 41, 42 sind dabei gemäß vorgegebenen Algorithmen programmiert und führen bei der Verarbeitung der Daten insbesondere logische Operationen durch. Die von einem vorgehenden Modul 40, 41 verarbeiteten Daten 70 sind dabei einem jeweils nachfolgenden Modul 40, 42 zuführbar. Die Module 40, 41, 42 sind also in Bezug auf einen Datenfluss seriell angeordnet.

Die programmierbaren Signalverarbeitungseinheit 10 umfasst auch eine Ausgangseinheit 23 zur Erfassung von verarbeiteten Daten 70. Die von einem letzten Modul 42 verarbeiteten Daten 70 sind der Ausgangseinheit 23 zuführbar. Die Ausgangseinheit 23 gibt die Ausgangssignale 63 an die Prozesssteuerung 16 aus.

Die programmierbaren Signalverarbeitungseinheit 10 umfasst einen Ausgangsmultiplexer 31. Der Ausgangsmultiplexer 31 ist derart mit den Modulen 40, 41, 42 verbunden, dass die von den Modulen 40, 41, 42 verarbeiteten Daten 70 dem Ausgangsmultiplexer 31 zuführbar sind. Der Ausgangsmultiplexer 31 ist auch derart mit der Sensoreingangseinheit 21 verbunden, dass die Sensordaten 71 dem Ausgangsmultiplexer 31 zuführbar sind.

Die programmierbare Signalverarbeitungseinheit 10 umfasst auch eine Testausgabeeinheit 25. Der Ausgangsmultiplexer 31 ist derart mit der Testausgabeeinheit 25 verbunden, dass von dem Ausgangsmultiplexer 31 ausgegebene Daten 75 der Testausgabeeinheit 25 zuführbar sind. Bei den von dem Ausgangsmultiplexer 31 ausgegebenen Daten 75 handelt es sich, je nach Ansteuerung des Ausgangsmultiplexers 31, um die von einem der Module 40, 41, 42 verarbeiteten Daten 70 oder um die Sensordaten 71. Der Testausgabeeinheit 25 sind somit wahlweise die von einem der Module 40, 41, 42 verarbeiteten Daten 70 oder die Sensordaten 71 zuführbar.

Die Testausgabeeinheit 25 ist mit dem Digitalrechner 14 verbunden und gibt Testausgangssignale 65 an den Digitalrechner 14 aus. Die Testausgangssignale 65 enthalten die von dem Ausgangsmultiplexer 31 ausgegebenen Daten 75. Die Testausgangssignale 65 enthalten wahlweise die von einem der Module 40, 41, 42 verarbeiteten Daten 70 oder die Sensordaten 71. Dem Digitalrechner 14 sind somit die von jedem der Module 40, 41, 42 verarbeiteten Daten 70 sowie die Sensordaten 71 zuführbar.

Die programmierbare Signalverarbeitungseinheit 10 umfasst auch eine Testeingabeeinheit 27. Die Testeingabeeinheit 27 ist mit dem Digitalrechner 14 verbunden und dient zur Erfassung von Testsignalen 67. Die Testeingabeeinheit 27 gibt digitale Testdaten 77 aus. Die Testdaten 77 enthalten die Testsignale 67.

Die programmierbare Signalverarbeitungseinheit 10 umfasst eine Mehrzahl von Eingangsmultiplexern 50, 51, 52, 53. Dabei ist ein erster Eingangsmultiplexer 51 derart mit dem ersten Modul 41, mit der Testeingabeeinheit 27 und mit der Sensoreingangseinheit 21 verbunden, dass je nach Ansteuerung des ersten Eingangsmultiplexers 51 dem ersten Modul 41 wahlweise die Sensordaten 71 oder die Testdaten 77 zuführbar sind.

Nachfolgende Eingangsmultiplexer 50, 52 sind derart mit den Modulen 40, 41, 42 und mit der Testeingabeeinheit 27 verbunden, dass je nach Ansteuerung des jeweiligen Eingangsmultiplexers 50, 52 jedem nachfolgenden Modul 40, 42 wahlweise die von einem vorgehenden Modul 40, 41 verarbeiteten Daten 70 oder die Testdaten 77 zuführbar sind. Insbesondere ist ein letzter Eingangsmultiplexer 52 derart mit dem letzten Modul 42, mit der Testeingabeeinheit 27 und mit einem vorgehenden Modul 40 verbunden, dass je nach Ansteuerung des letzten Eingangsmultiplexers 52 dem letzten Modul 40 wahlweise die von dem vorgehenden Modul 40 verarbeiteten Daten 70 oder die Testdaten 77 zuführbar sind.

Die programmierbare Signalverarbeitungseinheit 10 umfasst auch einen finalen Eingangsmultiplexer 53, der mit der Ausgangseinheit 23 verbunden ist. Von dem finalen Eingangsmultiplexer 53 ausgegebene Daten 73 werden der Ausgangseinheit 23 zugeführt. Die Ausgangssignale 63 enthalten die dem finalen Eingangsmultiplexer 53 ausgegebenen Daten 73. Die Ausgangseinheit 23 ist mit der Prozesssteuerung 16 verbunden und gibt die Ausgangssignale 63 an die Prozesssteuerung 16 aus.

Der finale Eingangsmultiplexer 53 ist derart mit dem letzten Modul 42, mit der Testeingabeeinheit 27 und mit der Ausgangseinheit 23 verbunden, dass je nach Ansteuerung des finalen Eingangsmultiplexers 53 der Ausgangseinheit 23 wahlweise die von dem letzten Modul 42 verarbeiteten Daten 70 oder die Testdaten 77 zuführbar sind. Die Ausgangssignale 63 enthalten somit wahlweise die von dem letzten Modul 42 verarbeiteten Daten 70 oder die Testdaten 77.

Die programmierbare Signalverarbeitungseinheit 10 umfasst eine Teststeuereinheit 29. Die Teststeuereinheit 29 ist mit dem Digitalrechner 14 verbunden und dient zur Erfassung von Steuersignalen 69. Die Teststeuereinheit 29 gibt digitale Steuerdaten 79 aus. Die Steuerdaten 79 enthalten die Steuersignale 69.

Die programmierbare Signalverarbeitungseinheit 10 umfasst einen Steuermultiplexer 33. Der Steuermultiplexer 33 ist mit den Eingangsmultiplexern 50, 51, 52, 53 und mit der Teststeuereinheit 29 verbunden. In Abhängigkeit von den Steuerdaten 79 sind die Eingangsmultiplexer 50, 51, 52, 53 über den Steuermultiplexer 33 ansteuerbar. Die Teststeuereinheit 29 ist auch mit dem Ausgangsmultiplexer 31 verbunden. In Abhängigkeit von den Steuerdaten 79 ist auch der Ausgangsmultiplexer 31 ansteuerbar.

Über die Testausgabeeinheit 25 sind dem Digitalrechner 14 wahlweise die von jedem der Module 40, 41, 42 verarbeiteten Daten 70 sowie die Sensordaten 71 zuführbar. Damit ist eine separate Überprüfung jedes einzelnen Moduls 40, 41, 42 ermöglicht. Über die Testeingabeeinheit 27 sind jedem der Module 40, 41, 42 sowie der Ausgangseinheit 23 ferner beliebige Testdaten 77 von dem Digitalrechner 14 zuführbar. Damit sind beliebige Zustände zum Testen jedes einzelnen Moduls 40, 41, 42 simulierbar.

### Bezugszeichenliste

- 10: Signalverarbeitungseinheit
- 12: Sensor
- 14: Digitalrechner
- 16: Prozesssteuerung
- 21: Sensoreingangseinheit
- 23: Ausgangseinheit
- 25: Testausgabeeinheit
- 27: Testeingabeeinheit
- 29: Teststeuereinheit
- 31: Ausgangsmultiplexer
- 33: Steuermultiplexer
- 40: Modul
- 41: erstes Modul
- 42: letztes Modul
- 50: Eingangsmultiplexer
- 51: erster Eingangsmultiplexer
- 52: letzter Eingangsmultiplexer
- 53: finaler Eingangsmultiplexer
- 61: Sensorsignale
- 63: Ausgangssignale
- 65: Testausgangssignale
- 67: Testsignale
- 69: Steuersignale
- 70: verarbeitete Daten
- 71: Sensordaten
- 73: von dem finalen Eingangsmultiplexer ausgegebene Daten
- 75: von dem Ausgangsmultiplexer ausgegebene Daten
- 77: Testdaten
- 79: Steuerdaten

## Patentansprüche

1. Programmierbare Signalverarbeitungseinheit (10), umfassend
eine Sensoreingangseinheit (21) zur Erfassung von Sensorsignalen (61) sowie zur Ausgabe von Sensordaten (71),
eine Mehrzahl von Modulen (40, 41, 42) zur Verarbeitung von Daten und
eine Ausgangseinheit (23) zur Erfassung von verarbeiteten Daten (70) sowie zur Ausgabe von Ausgangssignalen (63),
wobei die Sensordaten (71) einem ersten Modul (41) zuführbar sind,
und von einem letzten Modul (42) verarbeitete Daten (70) der Ausgangseinheit (23) zuführbar sind,
**dadurch gekennzeichnet, dass**
die programmierbare Signalverarbeitungseinheit (10)
eine Testausgabeeinheit (25) zur Ausgabe von Testausgangssignalen (65)
und einen Ausgangsmultiplexer (31)
umfasst,
wobei der Ausgangsmultiplexer (31) derart mit der Mehrzahl von Modulen (40, 41, 42) und mit der Testausgabeeinheit (25) verbunden ist, dass
von den Modulen (40, 41, 42) verarbeitete Daten (70) dem Ausgangsmultiplexer (31) zuführbar sind, und dass
von dem Ausgangsmultiplexer (31) ausgegebene Daten (75) der Testausgabeeinheit (25) zuführbar sind.

2. Programmierbare Signalverarbeitungseinheit (10) nach mindestens einem der vorangegangenen Ansprüche, **dadurch gekennzeichnet, dass**
die von einem vorgehenden Modul (40, 41) verarbeiteten Daten (70) einem jeweils nachfolgenden Modul (40, 42) zuführbar sind.

3. Programmierbare Signalverarbeitungseinheit (10) nach mindestens einem der vorangegangenen Ansprüche, **dadurch gekennzeichnet, dass**
der Ausgangsmultiplexer (31) derart mit der Sensoreingangseinheit (21) verbunden ist, dass die Sensordaten (71) dem Ausgangsmultiplexer (31) zuführbar sind.

4. Programmierbare Signalverarbeitungseinheit (10) nach mindestens einem der vorangegangenen Ansprüche, **dadurch gekennzeichnet, dass**
die programmierbare Signalverarbeitungseinheit (10)
eine Testeingabeeinheit (27) zur Erfassung von Testsignalen (67) sowie zur Ausgabe von Testdaten (77)
und eine Mehrzahl von Eingangsmultiplexern (50, 51, 52, 53)
umfasst,
wobei ein erster Eingangsmultiplexer (51) derart mit dem ersten Modul (41), mit der Testeingabeeinheit (27) und mit der Sensoreingangseinheit (21) verbunden ist, dass dem ersten Modul (41) wahlweise die Sensordaten (71) oder die Testdaten (77) zuführbar sind, und
wobei nachfolgende Eingangsmultiplexer (50, 52) derart mit den Modulen (40, 41, 42) und mit der Testeingabeeinheit (27) verbunden sind, dass
jedem nachfolgenden Modul (40, 42) wahlweise die von einem vorgehenden Modul (40, 41) verarbeiteten Daten (70) oder die Testdaten (77) zuführbar sind.

5. Programmierbare Signalverarbeitungseinheit (10) nach Anspruch 4,
**dadurch gekennzeichnet, dass**
ein finaler Eingangsmultiplexer (53) derart mit dem letzten Modul (42), mit der Testeingabeeinheit (27) und mit der Ausgangseinheit (23) verbunden ist, dass der Ausgangseinheit (23) wahlweise die von dem letzten Modul (42) verarbeiteten Daten (70) oder die Testdaten (77) zuführbar sind.

6. Programmierbare Signalverarbeitungseinheit (10) nach einem der Ansprüche 4 bis 5, **dadurch gekennzeichnet, dass**
die programmierbare Signalverarbeitungseinheit (10)
eine Teststeuereinheit (29) zur Erfassung von Steuersignalen (69) sowie zur Ausgabe von Steuerdaten (79)
und einen Steuermultiplexer (33)
umfasst,
wobei der Steuermultiplexer (33) derart mit den Eingangsmultiplexern (50, 51, 52, 53) und mit der Teststeuereinheit (29) verbunden ist, dass
in Abhängigkeit von den Steuerdaten (79) die Eingangsmultiplexer (50, 51, 52, 53) ansteuerbar sind.

7. Programmierbare Signalverarbeitungseinheit (10) nach Anspruch 6,
**dadurch gekennzeichnet, dass**
die Teststeuereinheit (29) derart mit dem Ausgangsmultiplexer (31) verbunden ist, dass in Abhängigkeit von den Steuerdaten (79) der Ausgangsmultiplexer (31) ansteuerbar ist.

8. Verfahren zum Betrieb einer programmierbaren Signalverarbeitungseinheit (10) nach mindestens einem der vorangegangenen Ansprüche, **dadurch gekennzeichnet, dass** von der Sensoreingangseinheit (21) Sensorsignale (61) erfasst und Sensordaten (71) ausgegeben werden;
von der Mehrzahl von Modulen (40, 41, 42) Daten verarbeitet werden;
von der Ausgangseinheit (23) Ausgangssignale (63) ausgegeben werden; wobei von den Modulen (40, 41, 42) verarbeitete Daten (70) dem Ausgangsmultiplexer (31) zugeführt werden;
von dem Ausgangsmultiplexer (31) ausgegebene Daten (75) der Testausgabeeinheit (25) zugeführt werden; und
von der Testausgabeeinheit (25) Testausgangssignale (65) ausgegeben werden.

9. Verfahren nach Anspruch 8, **dadurch gekennzeichnet, dass**
dem Ausgangsmultiplexer (31) die Sensordaten (71) zugeführt werden.

10. Verfahren nach einem der Ansprüche 8 bis 9, **dadurch gekennzeichnet, dass**
von einer Testeingabeeinheit (27) Testsignale (67) erfasst und Testdaten (77) ausgegeben werden; wobei
dem ersten Modul (41) über einen ersten Eingangsmultiplexer (51) wahlweise die Sensordaten (71) oder die Testdaten (77) zugeführt werden; und
jedem nachfolgenden Modul (40, 42) über einen nachfolgenden Eingangsmultiplexer (50, 52) wahlweise die von einem vorgehenden Modul (40, 41) verarbeiteten Daten (70) oder die Testdaten (77) zugeführt werden.

11. Verfahren nach einem der Ansprüche 8 bis 9, **dadurch gekennzeichnet, dass** der Ausgangseinheit (23) über einen finalen Eingangsmultiplexer (53) wahlweise die von dem letzten Modul (42) verarbeiteten Daten (70) oder die Testdaten (77) zugeführt werden.

## Claims

1. Programmable signal processing unit (10) comprising
a sensor input unit (21) for capturing sensor signals (61) and outputting sensor data (71),
a plurality of modules (40, 41, 42) for processing data and
an output unit (23) for capturing processed data (70) and outputting output signals (63),
the sensor data (71) being able to be supplied to a first module (41),
and data (70) processed by a last module (42) being able to be supplied to the output unit (23),
**characterised in that**
the programmable signal processing unit (10) comprises a test output unit (25) for outputting test output signals (65),
and an output multiplexer (31),
the output multiplexer (31) being connected to the plurality of modules (40, 41, 42) and to the test output unit (25) such that data (70) processed by the modules (40, 41, 42) can be supplied to the output multiplexer (31) and such that
data (75) output by the output multiplexer (31) can be supplied to the test output unit (25).

2. Programmable signal processing unit (10) according to at least one of the preceding claims,
**characterised in that**
the data (70) processed by a preceding module (40, 41) can be supplied in each case to a subsequent module (40, 42).

3. Programmable signal processing unit (10) according to at least one of the preceding claims,
**characterised in that**
the output multiplexer (31) is connected to the sensor input unit (21) such that the sensor data (71) can be supplied to the output multiplexer (31).

4. Programmable signal processing unit (10) according to at least one of the preceding claims,
**characterised in that**
the programmable signal processing unit (10) comprises a test input unit (27) for capturing test signals (67) and outputting test data (77),
and a plurality of input multiplexers (50, 51, 52, 53),
a first input multiplexer (51) being connected to the first module (41), to the test input unit (27) and to the sensor input unit (21) such that either the sensor data (71) or the test data (77) can be supplied to the first module (41), and
subsequent input multiplexers (50, 52) being connected to the modules (40, 41, 42) and to the test input unit (27) such that
either the data (70) processed by a preceding module (40, 41) or the test data (77) can be supplied to each subsequent module (40, 42).

5. Programmable signal processing unit (10) according to claim 4,
**characterised in that**
a final input multiplexer (53) is connected to the last module (42), to the test input unit (27) and to the output unit (23) such that either the data (70) processed by the last module (42) or the test data (77) can be supplied to the output unit (23).

6. Programmable signal processing unit (10) according to any of claims 4 to 5,
**characterised in that**
the programmable signal processing unit (10) comprises a test control unit (29) for capturing control signals (69) and outputting control data (79),
and a control multiplexer (33),
the control multiplexer (33) being connected to the input multiplexers (50, 51, 52, 53) and to the test control unit (29) such that
the input multiplexers (50, 51, 52, 53) can be activated on the basis of the control data (79).

7. Programmable signal processing unit (10) according to claim 6,
**characterised in that**
the test control unit (29) is connected to the output multiplexer (31) such that the output multiplexer (31) can be activated on the basis of the control data (79).

8. Method for operating a programmable signal processing unit (10) according to at least one of the preceding claims,
**characterised in that**
sensor signals (61) are captured by the sensor input unit (21) and sensor data (71) are output;
data are processed by the plurality of modules (40, 41, 42);
output signals (63) are output by the output unit (23);
data (70) processed by the modules (40, 41, 42) being supplied to the output multiplexer (31);
data (75) output by the output multiplexer (31) being supplied to the test output unit (25); and test output signals (65) being output by the test output unit (25).

9. Method according to claim 8,
**characterised in that**
the sensor data (71) are supplied to the output multiplexer (31).

10. Method according to any of claims 8 to 9,
**characterised in that**
test signals (67) are captured by a test input unit (27) and test data (77) are output;
either the sensor data (71) or the test data (77) being supplied to the first module (41) by means of a first input multiplexer (51); and
either the data (70) processed by a preceding module (40, 41) or the test data (77) being supplied to each subsequent module (40, 42) by means of a subsequent input multiplexer (50, 52).

11. Method according to any of claims 8 to 9,
**characterised in that**
either the data (70) processed by the last module (42) or the test data (77) are supplied to the output unit (23) by means of a final input multiplexer (53).

## Revendications

1. Unité de traitement de signal programmable (10), comprenant une unité d'entrée de capteur (21) permettant d'acquérir des signaux de capteur (61) et de fournir des données de capteur (71), une pluralité de modules (40, 41, 42) permettant de traiter des données et une unité de sortie (23) permettant d'acquérir des données (70) traitées et de fournir des signaux de sortie (63),
les données de capteur (71) pouvant être acheminées vers un premier module (41) et les données (70) traitées par un dernier module (42) pouvant être acheminées vers l'unité de sortie (23),
**caractérisée en ce que**
l'unité de traitement de signal programmable (10) comprend une unité de sortie de test (25) permettant de fournir des signaux de sortie de test (65) et un multiplexeur de sortie (31),
le multiplexeur de sortie (31) étant connecté à la pluralité de modules (40, 41, 42) et à l'unité de sortie de test (25) de telle manière que les données (70) traitées par les modules (40, 41, 42) peuvent être acheminées vers le multiplexeur de sortie (31) et **en ce que**
les données (75) fournies par le multiplexeur de sortie (31) peuvent être acheminées vers l'unité de sortie de test (25).

2. Unité de traitement de signal programmable (10) selon au moins l'une quelconque des revendications précédentes, **caractérisée en ce que**
les données (70) traitées par un module (40, 41) situé en amont peuvent être acheminées vers un module (40, 42) situé respectivement en aval.

3. Unité de traitement de signal programmable (10) selon au moins l'une quelconque des revendications précédentes, **caractérisée en ce que**
le multiplexeur de sortie (31) est connecté à l'unité d'entrée de capteur (21) de telle manière que les données de capteur (71) peuvent être acheminées vers le multiplexeur de sortie (31).

4. Unité de traitement de signal programmable (10) selon au moins l'une des revendications précédentes, **caractérisée en ce que**
l'unité de traitement de signal programmable (10) comprend
une unité d'entrée de test (27) permettant d'acquérir des signaux de test (67) et de fournir des données de test (77) et une pluralité de multiplexeurs d'entrée (50, 51, 52, 53),
un premier multiplexeur d'entrée (51) étant connecté au premier module (41), à l'unité d'entrée de test (27) et à l'unité d'entrée de capteur (21) de telle manière que les données de capteur (71) ou les données de test (77) peuvent être acheminées de manière sélective vers le premier module (41), et
des multiplexeurs d'entrée (50, 52) situés en aval étant connectés aux modules (40, 41, 42) et à l'unité d'entrée de test (27) de telle manière que les données (70) traitées par un module (40, 41) situé en amont ou les données de test (77) peuvent être acheminées de manière sélective vers chaque module (40, 42) situé en aval.

5. Unité de traitement de signal programmable (10) selon la revendication 4, **caractérisée en ce que**
un multiplexeur d'entrée (53) final est connecté au dernier module (42), à l'unité d'entrée de test (27) et à l'unité de sortie (23) de telle manière que les données (70) traitées par le dernier module (42) ou les données de test (77) peuvent être acheminées de manière sélective vers l'unité de sortie (23).

6. Unité de traitement de signal programmable (10) selon l'une quelconque des revendications 4 à 5, **caractérisée en ce que**
l'unité de traitement de signal programmable (10) comprend une unité de commande de test (29) permettant d'acquérir des signaux de commande (69) et de fournir des données de commande (79) et un multiplexeur de commande (33),
le multiplexeur de commande (33) étant connecté aux multiplexeurs d'entrée (50, 51, 52, 53) et à l'unité de commande de test (29) de telle manière que les multiplexeurs d'entrée (50, 51, 52, 53) peuvent être commandés en fonction des données de commande (79).

7. Unité de traitement de signal programmable (10) selon la revendication6, **caractérisée en ce que**
l'unité de commande de test (29) est connectée au multiplexeur de sortie (31) de telle manière que le multiplexeur de sortie (31) peut être commandé en fonction des données de commande (79).

8. Procédé d'exploitation d'une unité de traitement de signal programmable (10) selon au moins l'une quelconque des revendications précédentes, **caractérisé en ce que** des signaux de capteur (61) sont acquis par l'unité d'entrée de capteur (21) et des données de capteur (71) sont fournies ;
des données sont traitées par la pluralité de modules (40, 41, 42) ;
des signaux de sortie (63) sont fournis par l'unité de sortie (23) ;
des données (70) traitées par les modules (40, 41, 42) étant acheminées vers le multiplexeur de sortie (31) ;
des données (75) fournies par le multiplexeur de sortie (31) étant acheminées vers l'unité de sortie de test (25) ; et
des signaux de sortie de test (65) étant fournis par l'unité de sortie de test (25).

9. Procédé selon la revendication 8, **caractérisé en ce que**
les données de capteur (71) sont acheminées vers le multiplexeur de sortie (31).

10. Procédé selon l'une quelconque des revendications 8 à 9, **caractérisé en ce que** des signaux de test (67) sont acquis par une unité d'entrée de test (27) et des données de test (77) sont fournies ;
les données de capteur (71) ou les données de test (77) étant acheminées de manière sélective vers le premier module (41) par l'intermédiaire d'un premier multiplexeur d'entrée (51) ; et
les données (70) traitées par un module (40, 41) situé en amont ou les données de test (77) étant acheminées de manière sélective vers chaque module (40, 42) situé en aval par l'intermédiaire d'un multiplexeur d'entrée (50, 52) situé en aval.

11. Procédé selon l'une quelconque des revendications 8 à 9, **caractérisé en ce que** les données (70) traitées par le dernier module (42) ou les données de test (77) sont acheminées de manière sélective vers l'unité de sortie (23) par l'intermédiaire d'un multiplexeur d'entrée (53) final.
